# EUROPEAN PATENT SPECIFICATION

(11) **EP 4 753 076 B1**
(45) Date of publication and mention of the grant of the patent: **18.11.2026**
(21) Application number: 25208609.5
(22) Date of filing: 14.10.2025
(51) Int. Cl.: H01R 12/59, H01R 12/63

(54) **CONNECTOR**
VERBINDER
CONNECTEUR

(30) Priority: 27.11.2024 JP 2024206189
(43) Date of publication of application: 03.06.2026
(73) Proprietor: Japan Aviation Electronics Industry, Limited, Tokyo 150-0043 (JP)
(72) Inventor: KOMOTO, Tetsuya, Tokyo, 150-0043 (JP)
(74) Representative: Qip Patent & Recht Dr. Kuehn & Partner mbB

(56) References cited:
- EP-A1- 3 800 740
- EP-A1- 4 213 308
- EP-A2- 1 061 606
- US-A1- 2019 036 246

## Description

### BACKGROUND OF THE INVENTION

The present invention relates to a connector, particularly to a connector connected to a sheet type connection object.

In recent years, attention has been drawn to so-called smart clothes that can obtain user's biological data such as the heart rate and the body temperature only by being worn by the user. Such smart clothes have an electrode disposed at a measurement site, and when a wearable device serving as a measurement device is electrically connected to the electrode, biological data can be transmitted to the wearable device.

The electrode and the wearable device can be interconnected by use of, for instance, a connector connected to a conductor drawn from the electrode.

As a connector of this type, for example, JP 2018-129244 A discloses a connector as shown in FIG. 29. This connector includes a housing 2 and a base member 3 that are separately disposed on the opposite sides of a flexible substrate 1 to sandwich the flexible substrate 1. Tubular portions 4A of contacts 4 are passed through contact through holes 2A of the housing 2, and flanges 4B of the contacts 4 are sandwiched between the housing 2 and conductors 1A exposed on the top surface of the flexible substrate 1.

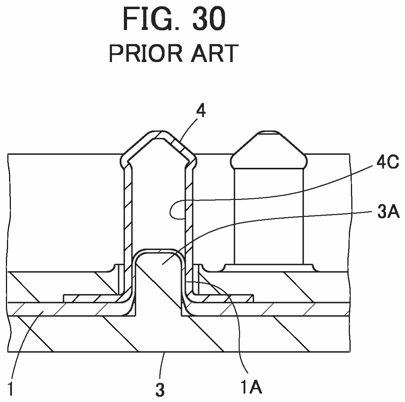

In this state, when the base member 3 is pushed toward the housing 2, as shown in FIG. 30, a projection 3A of the base member 3 is inserted into a projection accommodating portion 4C of the contact 4 with the flexible substrate 1 being sandwiched therebetween, and the inner surface of the projection accommodating portion 4C makes contact with the conductor 1A with a predetermined contact force, whereby the contact 4 is electrically connected to the conductor 1A.

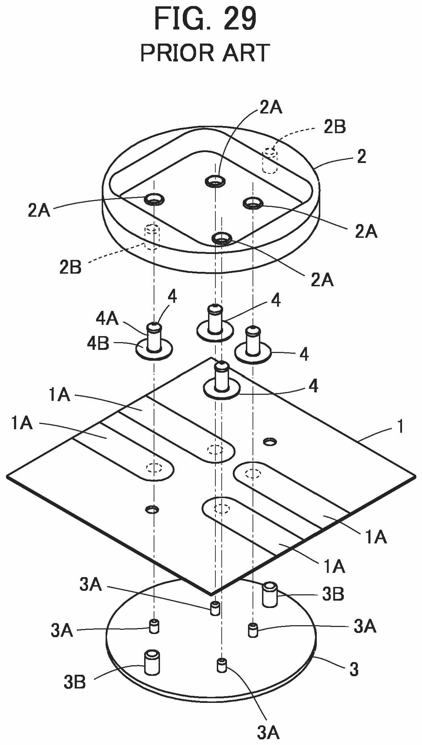

In addition, housing fixing posts 3B formed to project on the base member 3 are press-fitted into post accommodating portions 2B of the housing 2 as shown in FIG. 29, so that the housing 2 and the base member 3 are fixed to each other.

When fitted with the connector disclosed in JP 2018-129244 A, a wearable device can be connected to an electrode of a smart garment.

However, since the conductor 1A of the flexible substrate 1 is made contact with the inner surface of the projection accommodating portion 4C of the contact 4 by the lateral surface of the projection 3A inserted in the projection accommodating portion 4C of the contact 4, it is necessary to secure a contact portion having a predetermined dimension in the projecting direction of the projection 3A, that is, the height direction of the connector, resulting in an increase in overall height of the connector.

EP 1 061 606 A2 discloses a structure and method for connecting a flat cable to bus bars.

EP 3 800 740 A1 discloses a connector to be connected to a flexible conductor.

US 2019/0036246 A1 discloses an environmentally sealed, reusable connector for printed flexible electronics.

There is a demand for a thin connector as, for instance, a connector mounted on a smart garment.

### SUMMARY OF THE INVENTION

The present invention has been made to solve the conventional problem described above and is aimed at providing a connector that can be made thinner while enabling its connection to a sheet type connection object.

A connector according to the present invention as defined in claim 1 comprises inter alia:
a first insulator having, on its top surface, a first support surface extending in a predetermined direction;
a second insulator disposed in a stacking direction perpendicular to the predetermined direction with respect to the first insulator and having a second support surface that faces the first support surface;
a contact member held by the second insulator and having a contact portion exposed at the second support surface; and
a hold mechanism configured to hold the contact portion toward the first support surface,
wherein the first insulator has a first through hole penetrating the first insulator in the stacking direction from the first support surface to a bottom surface of the first insulator at a position corresponding to the contact portion,
the hold mechanism has a boss passing through the first through hole to a bottom surface side of the first insulator and holds the contact portion toward the first support surface by use of the boss, and
a part of a sheet type connection object, a conductive portion of which is exposed toward the second support surface, is sandwiched between the first support surface and the second support surface, and the contact portion makes contact with the conductive portion, whereby the contact member is electrically connected to the conductive portion.

### BRIEF DESCRIPTION OF THE DRAWINGS

FIG. 1 is a perspective view of a connector of Embodiment 1 connected to a connection object, as viewed from an obliquely upper position.
FIG. 2 is a perspective view of the connector of Embodiment 1 connected to the connection object, as viewed from an obliquely lower position.
FIG. 3 is an exploded perspective view of the connector according to Embodiment 1.
FIG. 4 is a perspective view showing a first insulator used in the connector of Embodiment 1.
FIG. 5 is a partial cross-sectional view showing the first insulator used in the connector of Embodiment 1.
FIG. 6 is a perspective view showing a second insulator used in the connector of Embodiment 1.
FIG. 7 is a partial cross-sectional view showing the second insulator used in the connector of Embodiment 1.
FIG. 8 is a perspective view of a contact member used in the connector of Embodiment 1, as viewed from an obliquely upper position.
FIG. 9 is a perspective view of the contact member used in the connector of Embodiment 1, as viewed from an obliquely lower position.
FIG. 10 is a perspective view of the connection object to be connected to the connector of Embodiment 1, as viewed from an obliquely upper position.
FIG. 11 is a cross-sectional view showing the connector of Embodiment 1 during connecting operation to the connection object.
FIG. 12 is a cross-sectional view showing the connector of Embodiment 1 having been connected to the connection object.
FIG. 13 is an enlarged partial view of FIG. 12.
FIG. 14 is a partial cross-sectional view showing a connector according to a modification of Embodiment 1 having been connected to the connection object.
FIG. 15 is a perspective view of a connector of Embodiment 2 connected to the connection object, as viewed from an obliquely upper position.
FIG. 16 is a perspective view of the connector of Embodiment 2 connected to the connection object, as viewed from an obliquely lower position.
FIG. 17 is an exploded perspective view of the connector according to Embodiment 2.
FIG. 18 is a perspective view showing a first insulator used in the connector of Embodiment 2.
FIG. 19 is a partial cross-sectional view showing the first insulator used in the connector of Embodiment 2.
FIG. 20 is a perspective view of a second insulator used in the connector of Embodiment 2, as viewed from an obliquely upper position.
FIG. 21 is a perspective view of the second insulator used in the connector of Embodiment 2, as viewed from an obliquely lower position.
FIG. 22 is a partial cross-sectional view showing the second insulator used in the connector of Embodiment 2.
FIG. 23 is a perspective view of a contact member used in the connector of Embodiment 2, as viewed from an obliquely upper position.
FIG. 24 is a perspective view of the contact member used in the connector of Embodiment 2, as viewed from an obliquely lower position.
FIG. 25 is a cross-sectional view showing the connector of Embodiment 2 during connecting operation to the connection object.
FIG. 26 is a cross-sectional view showing the connector of Embodiment 2 having been connected to the connection object.
FIG. 27 is an enlarged partial view of FIG. 26.
FIG. 28 is a partial cross-sectional view showing a connector according to a modification of Embodiment 2 having been connected to the connection object.
FIG. 29 is an exploded perspective view of a conventional connector.
FIG. 30 is a partial cross-sectional view showing the conventional connector.

### DETAILED DESCRIPTION OF THE INVENTION

Embodiments of the invention are described below based on the accompanying drawings.

### Embodiment 1

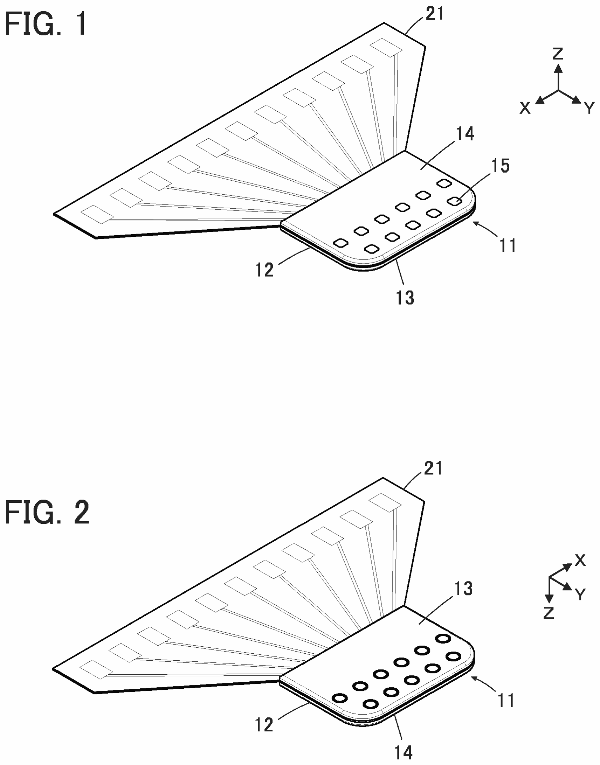

FIGS. 1 and 2 show a connector 11 according to Embodiment 1 connected to a sheet type conductive member 21. The connector 11 is used as, for instance, a garment-side connector for fitting a wearable device and includes a housing 12 of flat plate shape that is made of an insulating material. The housing 12 is composed of a first insulator 13 and a second insulator 14. The first insulator 13 and the second insulator 14 are stacked on and fixed to each other with a part of the sheet type conductive member 21 being sandwiched therebetween, whereby the housing 12 is attached to the sheet type conductive member 21.

The connector 11 also includes a plurality of contact members 15 held by the housing 12. The contact members 15 are aligned in two rows parallel to each other and, in this state, disposed in the housing 12.

For convenience, the sheet type conductive member 21 and the housing 12 are defined as extending along an XY plane, the direction in which the contact members 15 are aligned is called "X direction," and the direction in which the second insulator 14 is stacked with respect to the first insulator 13 is called "+Z direction."

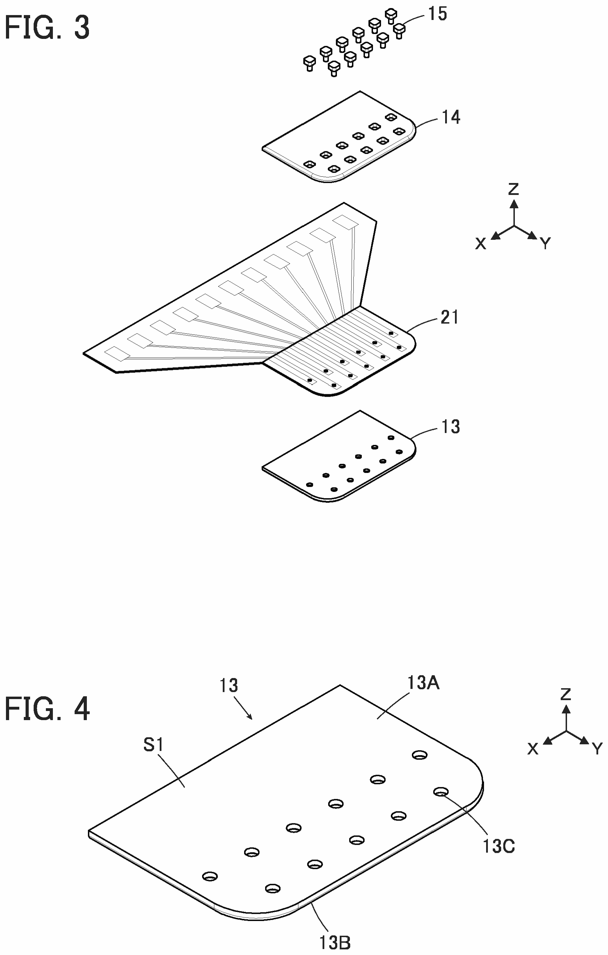

FIG. 3 shows an exploded perspective view of the connector 11. The sheet type conductive member 21 is disposed on the +Z direction side of the first insulator 13, the second insulator 14 is disposed on the +Z direction side of the sheet type conductive member 21, and the contact members 15 are disposed on the +Z direction side of the second insulator 14.

As shown in FIG. 4, the first insulator 13 has a flat plate shape extending along an XY plane and includes a top surface 13A facing in the +Z direction and a bottom surface 13B facing in the -Z direction.

The first insulator 13 is provided with a plurality of first through holes 13C penetrating the first insulator 13 from the top surface 13A to the bottom surface 13B in the Z direction. The first through holes 13C correspond to the contact members 15 and are aligned in two rows extending in the X direction and being parallel to each other.

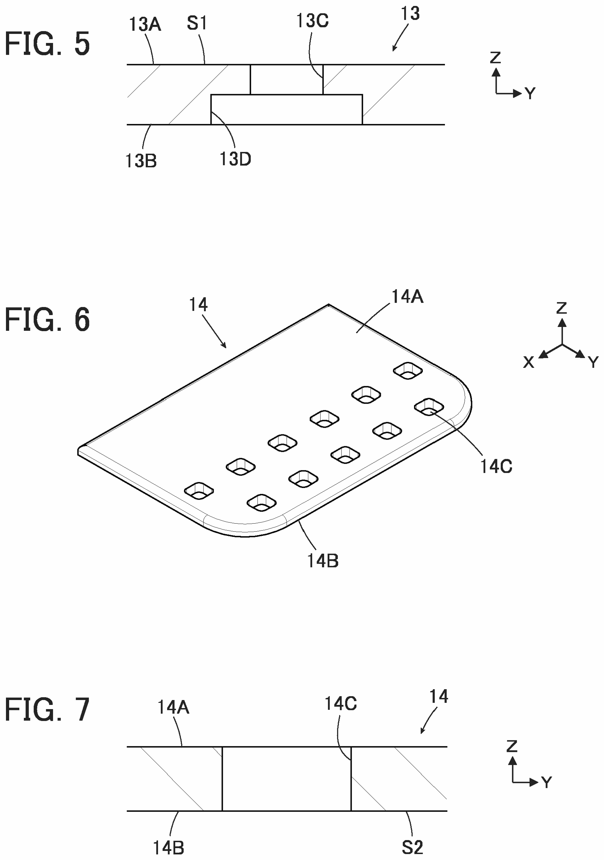

Further, as shown in FIG. 5, the first insulator 13 is provided at its bottom surface 13B with a recessed portion 13D that communicates with the corresponding first through hole 13C and that has a diameter larger than that of the first through hole 13C.

The top surface 13A of the first insulator 13 on the +Z direction side forms a first support surface S1 extending along an XY plane.

As shown in FIG. 6, the second insulator 14 has a flat plate shape extending along an XY plane and includes a top surface 14A facing in the +Z direction and a bottom surface 14B facing in the -Z direction.

The second insulator 14 is provided with a plurality of second through holes 14C penetrating the second insulator 14 from the top surface 14A to the bottom surface 14B in the Z direction. The second through holes 14C correspond to the contact members 15 and the first through holes 13C of the first insulator 13 and are aligned in two rows extending in the X direction and being parallel to each other.

The bottom surface 14B of the second insulator 14 on the -Z direction side forms a second support surface S2 extending along an XY plane, and the second through hole 14C opens at the second support surface S2, as shown in FIG. 7.

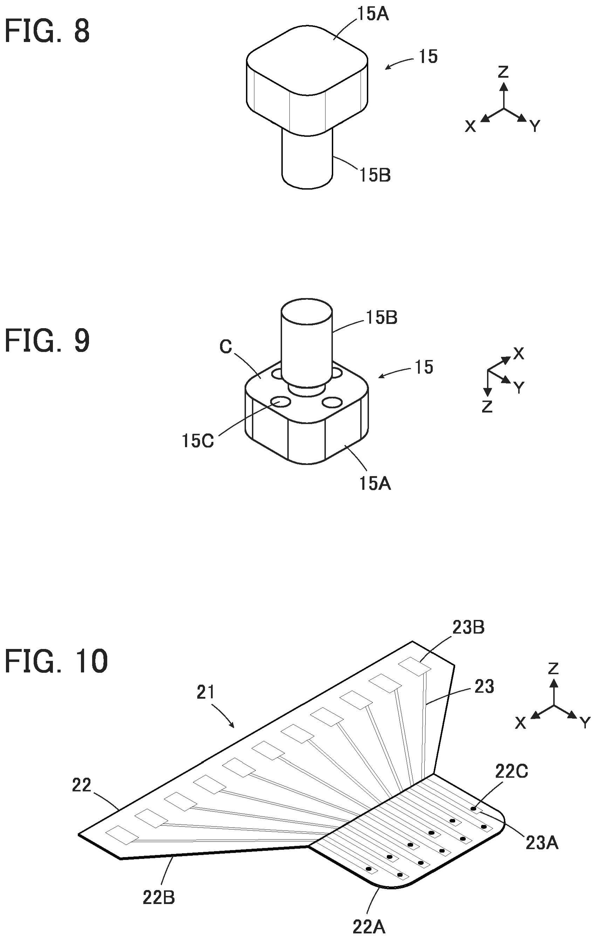

As shown in FIGS. 8 and 9, the contact member 15 is made of a conductive material such as metal and includes: a contact body 15A; and a boss 15B that is formed integrally with the contact body 15A and extends from the contact body 15A in the -Z direction.

The contact body 15A has the shape of a quadrangular prism whose central axis extends along the Z direction and whose corners are rounded. The surface of the contact body 15A on the -Z direction side extends along an XY plane and forms a contact portion C of the contact member 15.

The boss 15B has a pin shape and is formed to project in the -Z direction from a central portion of the contact portion C.

The contact portion C is provided with a plurality of protrusions 15C arranged around the boss 15B to surround the boss 15B and each protruding in the -Z direction.

The contact body 15A has a Z directional height substantially equal to the thickness of the second insulator 14 of flat plate shape and has a size in an XY plane that is slightly smaller than that of the second through hole 14C of the second insulator 14.

When the connector 11 is assembled, the contact body 15A is inserted into the second through hole 14C of the second insulator 14, and the contact portion C constituted of the surface, on the -Z direction side, of the contact body 15A is exposed at the second support surface S2 of the second insulator 14.

The boss 15B has a Z directional height larger in dimension than the sum of the thickness of the first insulator 13 of flat plate shape and the thickness of the sheet type conductive member 21 and has a diameter slightly smaller than that of the first through hole 13C of the first insulator 13.

The sheet type conductive member 21 is used for electrically connecting, for example, a plurality of wiring portions of a garment on which the connector 11 is mounted, to the contact members 15. As shown in FIG. 10, the sheet type conductive member 21 includes: a sheet body 22 formed of an insulating material; and conductive portions 23 formed on the sheet body 22.

The sheet body 22 has a first sheet portion 22A having a substantially rectangular shape extending along an XY plane and a second sheet portion 22B joined to the first sheet portion 22A and having a substantially trapezoidal shape extending along an XY plane. The first sheet portion 22A is a part sandwiched between the first insulator 13 and the second insulator 14 when the connector 11 is connected to the sheet type conductive member 21, and has a plurality of through holes 22C corresponding to the first through holes 13C of the first insulator 13 and the second through holes 14C of the second insulator 14.

The through hole 22C has a diameter that is substantially the same as that of the boss 15B of the contact member 15 and that is smaller than the size of the contact body 15A in an XY plane.

The conductive portions 23 have a conductive pattern exposed at least on the +Z direction side of the sheet body 22. The conductive pattern has: a plurality of first connection portions 23A corresponding to the through holes 22C and disposed to include the corresponding through holes 22C; and a plurality of second connection portions 23B disposed in the second sheet portion 22B and connected to the first connection portions 23A of the first sheet portion 22A.

For the sheet type conductive member 21, various conductive members are usable, such as a member obtained by forming a conductive portion 23 constituted of a conductive layer on a surface, on the +Z direction side, of the sheet body 22 made of an insulating material such as resin, a member obtained by forming a conductive portion 23 constituted of a conductive layer on a surface of the sheet body 22 made of insulating cloth or knitted fabric by printing, and a member obtained by forming a conductive portion 23 by sewing or weaving the conductive portion 23 into the sheet body 22 made of insulating cloth or knitted fabric. However, the conductive portion 23 needs to be exposed at least on the +Z direction side of the sheet body 22.

When the connector 11 is assembled, first, the first through holes 13C of the first insulator 13, the through holes 22C of the sheet type conductive member 21, and the second through holes 14C of the second insulator 14 are aligned one another, and in this state, the first sheet portion 22A of the sheet type conductive member 21 is sandwiched between the first support surface S1 of the first insulator 13 and the second support surface S2 of the second insulator 14.

In other words, the first sheet portion 22A of the sheet type conductive member 21 is disposed on the +Z direction side of the first insulator 13, and further, the second insulator 14 is disposed on the +Z direction side of the first sheet portion 22A of the sheet type conductive member 21.

Next, the contact members 15 are inserted from the +Z direction into, sequentially, the second through holes 14C of the second insulator 14, the through holes 22C of the sheet type conductive member 21, and the first through holes 13C of the first insulator 13.

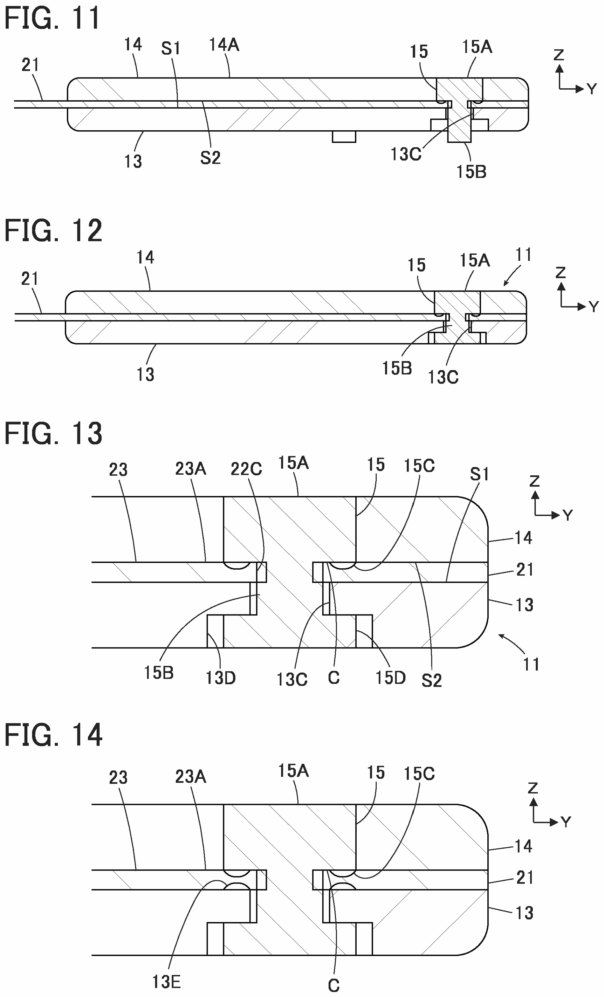

Since the contact body 15A of the contact member 15 has a Z directional height substantially equal to the thickness of the second insulator 14 and the boss 15B has a Z directional height larger in dimension than the sum of the thickness of the first insulator 13 and the thickness of the sheet type conductive member 21, as shown in FIG. 11, the surface of the contact body 15A on the +Z direction side forms a substantially same plane with the top surface 14A of the second insulator 14, and the end of the boss 15B protrudes from the first through hole 13C of the first insulator 13 in the -Z direction.

Then, the ends of the bosses 15B of the contact members 15 protruding from the first through holes 13C of the first insulator 13 in the -Z direction are each deformed as shown in FIG. 12.

Consequently, as shown in FIG. 13, the deformed end of the boss 15B is accommodated in the recessed portion 13D communicating with the first through hole 13C of the first insulator 13, and an overhang portion 15D is formed to overhang from the first through hole 13C along an XY plane.

The assembling operation of the connector 11 is thus completed.

At this time, the surfaces, on the +Z direction side, of the contact bodies 15A of the contact members 15 are in the state of being exposed from the second insulator 14.

The contact member 15 having the contact portion C, the boss 15B, and the overhang portion 15D forms a hold mechanism serving to hold the contact portion C toward the first support surface S1 of the first insulator 13. Specifically, those portions of the first insulator 13 and the sheet type conductive member 21 which are situated around the first through hole 13C are sandwiched between the contact portion C and the overhang portion 15D of the contact member 15, so that the contact portion C of the contact member 15 is held toward the first support surface S1 of the first insulator 13.

As a result, the contact portion C exposed at the second support surface S2 of the second insulator 14 makes contact with the first connection portion 23A of the conductive portion 23 exposed on the +Z direction side in the vicinity of the through hole 22C of the sheet type conductive member 21, whereby the contact member 15 is electrically connected to the conductive portion 23 of the sheet type conductive member 21.

It should be noted that since the contact portion C of each contact member 15 is provided with the protrusions 15C protruding in the -Z direction toward the first support surface S1 of the first insulator 13, the reliability improves in electrical connection between the contact member 15 and the conductive portion 23 of the sheet type conductive member 21.

In addition, as shown in FIG. 14, there may be provided a plurality of protrusions 13E protruding in the +Z direction from the first support surface S1 of the first insulator 13 toward the contact portion C at positions corresponding to the contact portion C of the contact member 15. With this configuration, a compression force in the Z direction acts on the sheet type conductive member 21 owing to the protrusions 15C of the contact member 15 and the protrusions 13E of the first insulator 13, thus further improving the reliability of electrical connection between the contact member 15 and the conductive portion 23 of the sheet type conductive member 21.

Alternatively, even when the protrusions 13E are only formed on the first support surface S1 of the first insulator 13 without formation of the protrusions 15C on the contact member 15, the reliability still improves in electrical connection between the contact member 15 and the conductive portion 23 of the sheet type conductive member 21.

The number of the protrusions 15C of the contact member 15 or the protrusions 13E of the first insulator 13 is not limited to a plural number, and it suffices if at least one protrusion 15C or 13E is provided.

Preferably, the first support surface S1 of the first insulator 13, the first sheet portion 22A of the sheet type conductive member 21, and the second support surface S2 of the second insulator 14 are bonded together by an adhesive or the like. For instance, an adhesive sheet is interposed between the first support surface S1 and the first sheet portion 22A and also between the first sheet portion 22A and the second support surface S2 and heated to melt, whereby the first insulator 13, the sheet type conductive member 21, and the second insulator 14 can be bonded together. Thus, the connector 11 having waterproof function is formed.

The overhang portion 15D of each contact member 15 can be formed by mechanically processing and deforming the end of the boss 15B. The end of the boss 15B may be deformed by applying a compression force in the Z direction to the boss 15B while using heat applied in bonding of the first insulator 13, the sheet type conductive member 21, and the second insulator 14.

The first insulator 13 and the second insulator 14 may be formed from a resin material having flexibility such as a flexible epoxy resin, a rubber material, or other materials. With the use of the first and second insulators 13 and 14 thus having flexibility, comfortableness of a garment can be improved when the connector 11 is used as a garment-side connector.

### Embodiment 2

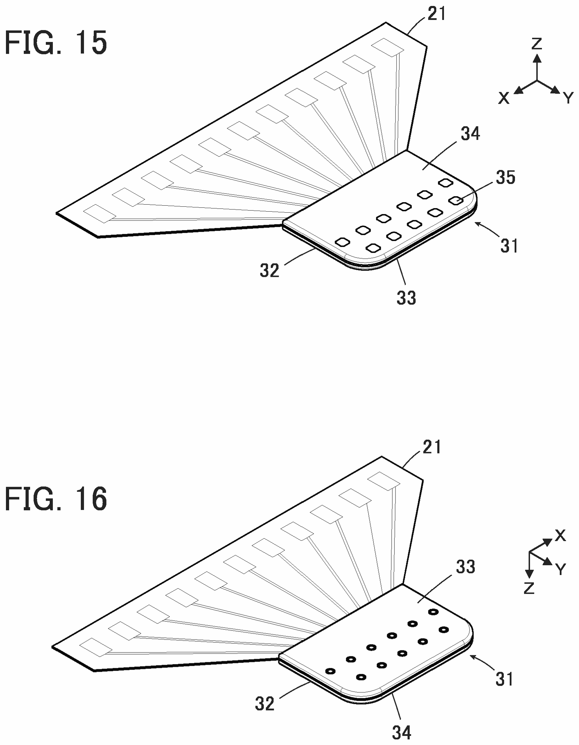

FIGS. 15 and 16 show a connector 31 according to Embodiment 2 connected to the sheet type conductive member 21. As with the connector 11 of Embodiment 1, the connector 31 is used as, for instance, a garment-side connector for fitting a wearable device and includes a housing 32 of flat plate shape that is made of an insulating material. The housing 32 is composed of a first insulator 33 and a second insulator 34.

The sheet type conductive member 21 herein is the same as that used in Embodiment 1.

The connector 31 also includes a plurality of contact members 35 held by the housing 32. The contact members 35 are aligned in two rows parallel to each other and, in this state, disposed in the housing 32.

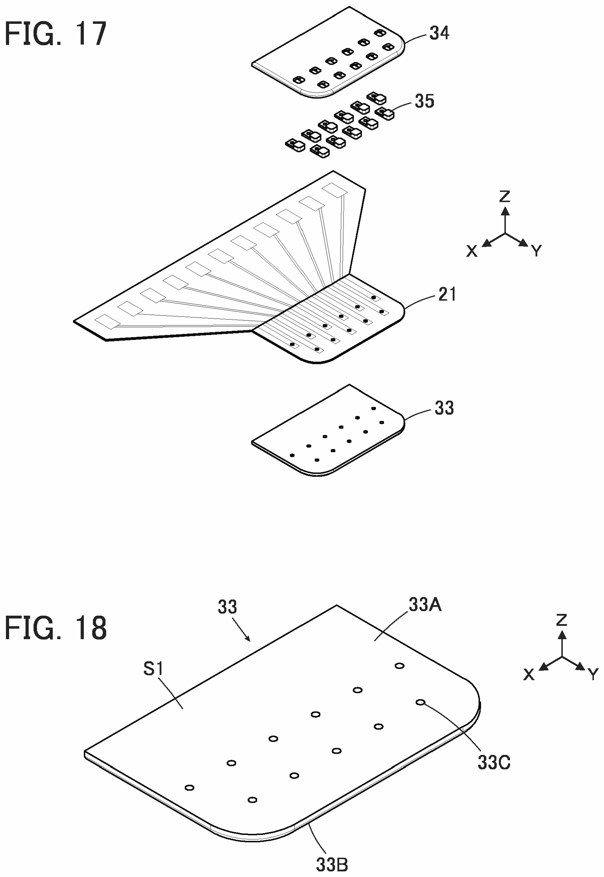

FIG. 17 shows an exploded perspective view of the connector 31. The sheet type conductive member 21 is disposed on the +Z direction side of the first insulator 33, the contact members 35 are disposed on the +Z direction side of the sheet type conductive member 21, and the second insulator 34 is disposed on the +Z direction side of the contact members 35.

As shown in FIG. 18, the first insulator 33 has a flat plate shape extending along an XY plane and includes a top surface 33A facing in the +Z direction and a bottom surface 33B facing in the -Z direction.

The first insulator 33 is provided with a plurality of first through holes 33C penetrating the first insulator 33 from the top surface 33A to the bottom surface 33B in the Z direction. The first through holes 33C correspond to the contact members 35 and are aligned in two rows extending in the X direction and being parallel to each other.

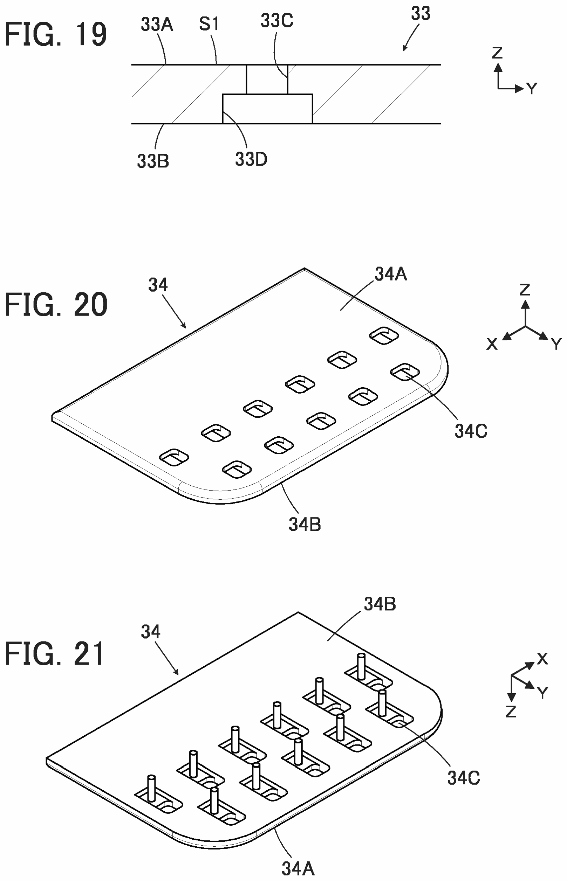

Further, the first insulator 33 is provided at its bottom surface 33B with a recessed portion 33D that communicates with the corresponding first through hole 33C and that has a larger diameter than that of the first through hole 33C, as shown in FIG. 19.

The top surface 33A of the first insulator 33 on the +Z direction side forms a first support surface S1 extending along an XY plane.

As shown in FIGS. 20 and 21, the second insulator 34 has a flat plate shape extending along an XY plane and includes a top surface 34A facing in the +Z direction and a bottom surface 34B facing in the -Z direction.

The second insulator 34 is provided with a plurality of second through holes 34C penetrating the second insulator 34 from the top surface 34A to the bottom surface 34B in the Z direction. The second through holes 34C correspond to the contact members 35 and the first through holes 33C of the first insulator 33 and are aligned in two rows extending in the X direction and being parallel to each other.

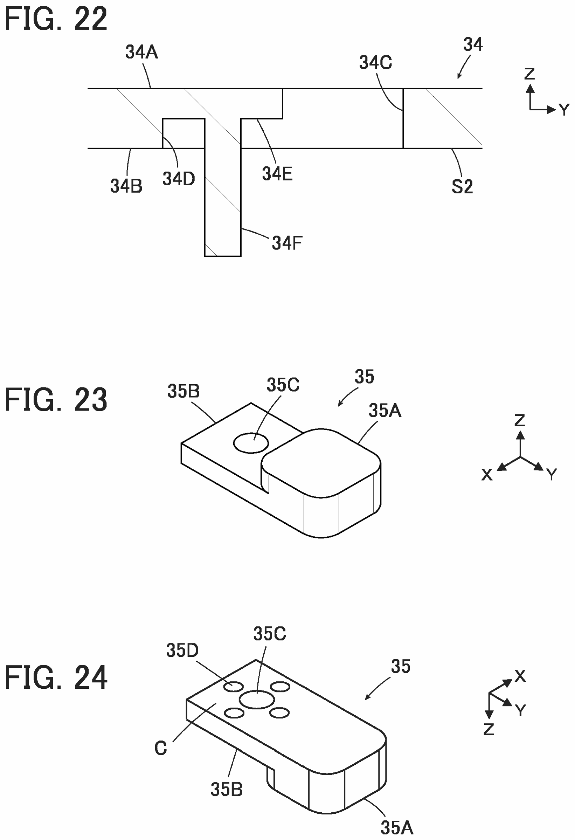

As shown in FIG. 22, the second insulator 34 is provided at its bottom surface 34B with a recessed portion 34D that communicates with the corresponding second through hole 34C and that is adjacent to the second through hole 34C in the -Y direction. The recessed portion 34D opens toward the -Z direction.

Further, the recessed portion 34D facing in the -Z direction is provided at its bottom surface 34E with a pin-shaped boss 34F that projects and extends in the -Z direction. The boss 34F has a Z directional height larger in dimension than the sum of the thickness of the first insulator 33 of flat plate shape, the thickness of the sheet type conductive member 21, and the depth of the recessed portion 34D.

The bottom surface 34B of the second insulator 34 on the -Z direction side forms a second support surface S2 extending along an XY plane, and the second through hole 34C and the recessed portion 34D open at the second support surface S2.

As shown in FIGS. 23 and 24, the contact member 35 is made of a conductive material such as metal and includes a contact body 35A and a flat plate portion 35B that is adjacent to the contact body 35A in the -Y direction. The flat plate portion 35B is formed to be thinner than the height dimension in the Z direction of the contact body 35A, and the surface of the contact body 35A on the -Z direction side and the surface of the flat plate portion 35B on the -Z direction side together form the same plane.

The flat plate portion 35B is provided at its central portion with a contact through hole 35C penetrating the flat plate portion 35B in the Z direction, and the surface of the flat plate portion 35B on the -Z direction side forms a contact portion C extending along an XY plane.

The contact portion C is provided with a plurality of protrusions 35D arranged around the contact through hole 35C to surround the contact through hole 35C and each protruding in the -Z direction.

The contact body 35A has a Z directional height substantially equal to the thickness of the second insulator 34 of flat plate shape and has a size in an XY plane that is slightly smaller than that of the second through hole 34C of the second insulator 34.

The flat plate portion 35B has a Z directional height substantially equal to the depth of the recessed portion 34D of the second insulator 34 and has a size in an XY plane that is slightly smaller than that of the recessed portion 34D.

When the connector 31 is assembled, the flat plate portion 35B is inserted into the recessed portion 34D of the second insulator 34, and the contact portion C constituted of the surface, on the -Z direction side, of the flat plate portion 35B is exposed at the second support surface S2 of the second insulator 34.

The contact through hole 35C has a diameter slightly larger than that of the boss 34F of the second insulator 34.

When the connector 31 is assembled, first, the contact members 35 are moved with respect to the second insulator 34 from the -Z direction such that the bosses 34F of the second insulator 34 penetrate the contact through holes 35C of the contact members 35, whereby the contact members 35 are held by the second insulator 34.

In this process, the contact body 35A of each contact member 35 is inserted into the corresponding second through hole 34C of the second insulator 34, and the flat plate portion 35B of each contact member 35 is inserted into the corresponding recessed portion 34D of the second insulator 34.

Since the contact body 35A of the contact member 35 has a Z directional height substantially equal to the thickness of the second insulator 34 and the flat plate portion 35B has a Z directional height substantially equal to the depth of the recessed portion 34D of the second insulator 34, the surface of the contact body 35A on the +Z direction side forms a substantially same plane with the top surface 34A of the second insulator 34, and the surfaces of the contact body 35A and the flat plate portion 35B on the -Z direction side form a substantially same plane with the bottom surface 34B of the second insulator 34.

Next, the first through holes 33C of the first insulator 33, the through holes 22C of the sheet type conductive member 21, and the contact members 35 held by the second insulator 34 are aligned one another, and in this state, the first sheet portion 22A of the sheet type conductive member 21 is sandwiched between the first support surface S1 of the first insulator 33 and the second support surface S2 of the second insulator 34.

In this process, the bosses 34F of the second insulator 34 are inserted into, sequentially, the through holes 22C of the sheet type conductive member 21 and the first through holes 33C of the first insulator 33.

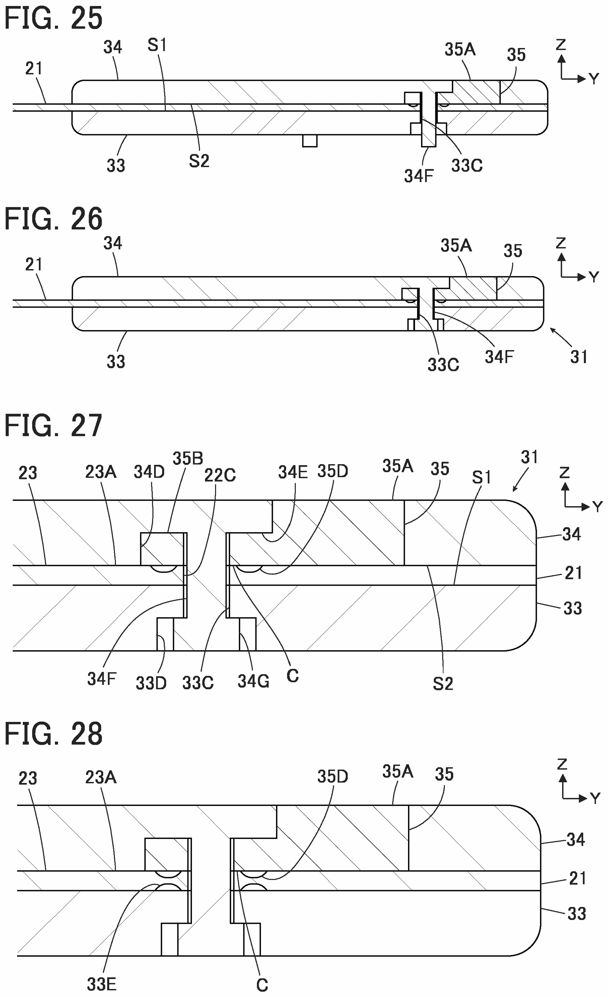

Since the boss 34F of the second insulator 34 has a Z directional height larger in dimension than the sum of the thickness of the first insulator 33, the thickness of the sheet type conductive member 21, and the depth of the recessed portion 34D, as shown in FIG. 25, the end of the boss 34F protrudes from the first through hole 33C of the first insulator 33 in the -Z direction.

Then, the ends of the bosses 34F of the second insulator 34 protruding from the first through holes 33C of the first insulator 33 in the -Z direction are each deformed as shown in FIG. 26.

Consequently, as shown in FIG. 27, the deformed end of the boss 34F is accommodated in the recessed portion 33D communicating with the first through hole 33C of the first insulator 33, and an overhang portion 34G is formed to overhang from the first through hole 33C along an XY plane.

The assembling operation of the connector 31 is thus completed.

At this time, the surfaces, on the +Z direction side, of the contact bodies 35A of the contact members 35 are in the state of being exposed from the second insulator 34.

The second insulator 34 having the recessed portion 34D, the boss 34F, and the overhang portion 34G forms a hold mechanism serving to hold the contact portion C of the contact member 35 toward the first support surface S1 of the first insulator 33. Specifically, the flat plate portion 35B of the contact member 35 and those portions of the first insulator 33 and the sheet type conductive member 21 which are situated around the first through hole 33C are sandwiched between the bottom surface 34E of the recessed portion 34D and the overhang portion 34G, so that the contact portion C of the contact member 35 is held toward the first support surface S1 of the first insulator 33.

As a result, the contact portion C exposed at the second support surface S2 of the second insulator 34 makes contact with the first connection portion 23A of the conductive portion 23 exposed on the +Z direction side in the vicinity of the through hole 22C of the sheet type conductive member 21, whereby the contact member 35 is electrically connected to the conductive portion 23 of the sheet type conductive member 21.

It should be noted that since the contact portion C of each contact member 35 is provided with the protrusions 35D protruding in the -Z direction toward the first support surface S1 of the first insulator 33, the reliability improves in electrical connection between the contact member 35 and the conductive portion 23 of the sheet type conductive member 21.

In addition, as shown in FIG. 28, there may be provided a plurality of protrusions 33E protruding in the +Z direction from the first support surface S1 of the first insulator 33 toward the contact portion C at positions corresponding to the contact portion C of the contact member 35. With this configuration, a compression force in the Z direction acts on the sheet type conductive member 21 owing to the protrusions 35D of the contact member 35 and the protrusions 33E of the first insulator 33, thus further improving the reliability of electrical connection between the contact member 35 and the conductive portion 23 of the sheet type conductive member 21.

Alternatively, even when the protrusions 33E are only formed on the first support surface S1 of the first insulator 33 without formation of the protrusions 35D on the contact member 35, the reliability still improves in electrical connection between the contact member 35 and the conductive portion 23 of the sheet type conductive member 21.

The number of the protrusions 35D of the contact member 35 or the protrusions 33E of the first insulator 33 is not limited to a plural number, and it suffices if at least one protrusion 35D or 33E is provided.

Preferably, the first support surface S1 of the first insulator 33, the first sheet portion 22A of the sheet type conductive member 21, and the second support surface S2 of the second insulator 34 are bonded together by an adhesive or the like. For instance, an adhesive sheet is interposed between the first support surface S1 and the first sheet portion 22A and also between the first sheet portion 22A and the second support surface S2 and heated to melt, whereby the first insulator 33, the sheet type conductive member 21, and the second insulator 34 can be bonded together. Thus, the connector 31 having waterproof function is formed.

The overhang portions 34G of the second insulator 34 can be formed by deforming the ends of the respective bosses 34F by heat.

In the case where the connector 11 of Embodiment 1 and the connector 31 of Embodiment 2 as described above are each mounted on, for example, a garment, the second connection portions 23B disposed on the second sheet portion 22B of the sheet type conductive member 21 shown in FIG. 10 are connected to a plurality of wiring portions of the garment. Then, a counter connector (not shown) is fitted to the connector 11, 31, and a plurality of contact members of the counter connector make contact with the contact bodies 15A, 35A of the contact members 15, 35 exposed from the housing 12, 32.

It should be noted that in the connector according to the invention, the number of the contact members 15 in the connector 11 of Embodiment 1 and the number of the contact members 35 in the connector 31 of Embodiment 2 are not limited, and it suffices if there is at least one contact member 15, 35 electrically connected to the conductive portion 23 of the sheet type conductive member 21.

## Claims

1. A connector comprising:
a first insulator (13, 33) having a flat plate shape extending along an XY plane and including a top surface (13A, 33A) facing in a +Z direction and a bottom surface (13B, 33B) facing in a -Z direction, the first insulator (13, 33) having, on its top surface, a first support surface (S1) extending in a predetermined direction;
a second insulator (14, 34) having a flat plate shape extending along an XY plane and including a top surface (14A, 34A) facing in the +Z direction and a bottom surface (14B, 34B) facing in the -Z direction, the second insulator being disposed in a stacking direction perpendicular to the predetermined direction with respect to the first insulator and having a second support surface (S2) that faces the first support surface;
a contact member (15, 35) held by the second insulator and having a contact portion (C) exposed at the second support surface, and
a hold mechanism (15, 34) configured to hold the contact portion toward the first support surface,
wherein the first insulator has a first through hole (13C, 33C) penetrating the first insulator in the stacking direction from the first support surface to a bottom surface of the first insulator at a position corresponding to the contact portion,
the hold mechanism has a boss (15B, 34F) passing through the first through hole to a bottom surface side of the first insulator and holds the contact portion toward the first support surface by use of the boss, and
wherein the connector is configured such that a part of a sheet type connection object (21), a conductive portion (23) of which is exposed toward the second support surface, is to be sandwiched between the first support surface and the second support surface, and the contact portion is to make contact with the conductive portion, whereby the contact member is electrically connected to the conductive portion,
**characterized in that**:
the contact member includes a contact body (15A, 35A) having a Z directional height substantially equal to a thickness of the second insulator, a surface of the contact body (15A, 35A) on the +Z direction side forming a substantially same plane with the top surface (14A, 34A) of the second insulator and being exposed from the second insulator.

2. The connector according to claim 1,
wherein the hold mechanism is formed of the contact member (15), and
the contact member (15) includes the boss (15B) formed to project from the contact portion, and an overhang portion (15D) formed at an end of the boss and overhanging from the first through hole in the predetermined direction on the bottom surface side of the first insulator.

3. The connector according to claim 2,
wherein the second insulator (14) has a second through hole (14C) penetrating the second insulator in the stacking direction and opening at the second support surface, and
the contact member (15) has a contact body (15A) inserted in the second through hole and provided with the contact portion.

4. The connector according to claim 2 or 3,
wherein the first insulator (13) and the second insulator (14) have flexibility.

5. The connector according to claim 1,
wherein the contact member (35) has a contact through hole (35C) that penetrates the contact member in the stacking direction so as to pass the contact portion and that communicates with the first through hole,
the hold mechanism is formed of the second insulator (34), and
the second insulator (34) includes the boss (34F) passing through the contact through hole and the first through hole to the bottom surface side of the first insulator, and an overhang portion (34G) formed at an end of the boss and overhanging from the first through hole in the predetermined direction on the bottom surface side of the first insulator.

6. The connector according to claim 5,
wherein the second insulator (34) has a second through hole (34C) penetrating the second insulator in the stacking direction and a recessed portion (34D) communicating with the second through hole and opening at the second support surface,
the contact member (35) has a contact body (35A) inserted in the second through hole and a flat plate portion (35B) adjacent to the contact body and inserted in the recessed portion, and
the contact portion (C) and the contact through hole (35C) are formed in the flat plate portion.

7. The connector according to any one of claims 1-6,
wherein the contact portion (C) has at least one protrusion (15C, 35D) protruding toward the first support surface (S1) of the first insulator (13, 33).

8. The connector according to any one of claims 1-7,
wherein the first insulator (13, 33) has at least one protrusion (13E, 33E) protruding from the first support surface toward the contact portion of the contact member at a position corresponding to the contact portion (C).

9. The connector according to any one of claims 1-8, comprising a plurality of the contact members (15, 35) held by the second insulator (14, 34),
wherein the first insulator (13, 33) has a plurality of the first through holes (13C, 33C) corresponding to the plurality of the contact members, and
a part of the sheet type connection object (21), a plurality of the conductive portions (23) of which are exposed toward the second support surface, is sandwiched between the first support surface and the second support surface, and the contact portions of the plurality of the contact members make contact with the plurality of the conductive portions, whereby the plurality of the contact members are electrically connected to the plurality of the conductive portions.

## Patentansprüche

1. Verbinder, umfassend:
einen ersten Isolator (13, 33), der eine flache Plattenform aufweist, die sich entlang einer XY-Ebene erstreckt und die eine obere Oberfläche (13A, 33A), die in eine +Z-Richtung weist, und eine untere Oberfläche (13B, 33B), die in eine -Z-Richtung weist, beinhaltet, wobei der erste Isolator (13, 33) an seiner oberen Oberfläche eine erste Trägeroberfläche (S1) aufweist, die sich in eine vorbestimmte Richtung erstreckt;
einen zweiten Isolator (14, 34), der eine flache Plattenform aufweist, die sich entlang einer XY-Ebene erstreckt und die eine obere Oberfläche (14A, 34A), die in die +Z-Richtung weist, und eine untere Oberfläche (14B, 34B), die in die -Z-Richtung weist, aufweist, wobei der zweite Isolator in einer Stapelrichtung senkrecht zu der vorbestimmten Richtung in Bezug auf den ersten Isolator angeordnet ist und eine zweite Trägeroberfläche (S2) aufweist, die der ersten Trägeroberfläche zugewandt ist;
ein Kontaktelement (15, 35), das durch den zweiten Isolator gehalten wird und einen Kontaktabschnitt (C) aufweist, der an der zweiten Trägeroberfläche freiliegt, und
einen Haltemechanismus (15, 34), der konfiguriert ist, um den Kontaktabschnitt hin zu der ersten Trägeroberfläche zu halten,
wobei der erste Isolator ein erstes Durchgangsloch (13C, 33C) aufweist, das den ersten Isolator in der Stapelrichtung von der ersten Trägeroberfläche zu einer unteren Oberfläche des ersten Isolators an einer Position, die dem Kontaktabschnitt entspricht, durchdringt,
der Haltemechanismus einen Vorsprung (15B, 34F) aufweist, der durch das erste Durchgangsloch zu einer Seite der unteren Oberflächen des ersten Isolators verläuft und den Kontaktabschnitt hin zu der ersten Trägeroberfläche unter Verwendung des Vorsprungs hält, und
wobei der Verbinder derart konfiguriert ist, dass ein Teil eines schichtartigen Verbindungsobjekts (21), von dem ein leitfähiger Abschnitt (23) hin zu der zweiten Trägeroberfläche freiliegt, zwischen der ersten Trägeroberfläche und der zweiten Trägeroberfläche sandwichartig anzuordnen ist, und der Kontaktabschnitt mit dem leitfähigen Abschnitt in Kontakt zu bringen ist, wodurch das Kontaktelement elektrisch mit dem leitfähigen Abschnitt verbunden ist,
**dadurch gekennzeichnet, dass**
das Kontaktelement einen Kontaktkörper (15A, 35A) beinhaltet, der eine Höhe in Z-Richtung aufweist, die im Wesentlichen gleich einer Dicke des zweiten Isolators ist, wobei eine Oberfläche des Kontaktkörpers (15A, 35A) an der Seite der +Z-Richtung eine im Wesentlichen gleiche Ebene mit der oberen Oberfläche (14A, 34A) des zweiten Isolators bildet und von dem zweiten Isolator freiliegt.

2. Verbinder nach Anspruch 1,
wobei der Haltemechanismus aus dem Kontaktelement (15) gebildet ist, und
das Kontaktelement (15) den Vorsprung (15B), der gebildet ist, um von dem Kontaktabschnitt vorzustehen, und einen Überhangabschnitt (15D), der an einem Ende des Vorsprungs gebildet ist und von dem ersten Durchgangsloch in der vorbestimmten Richtung auf der unteren Oberflächenseite des ersten Isolators überhängt, beinhaltet.

3. Verbinder nach Anspruch 2,
wobei der zweite Isolator (14) ein zweites Durchgangsloch (14C) aufweist, das den zweiten Isolator in der Stapelrichtung durchdringt und sich an der zweiten Trägeroberfläche öffnet, und
das Kontaktelement (15) einen Kontaktkörper (15A) aufweist, der in das zweite Durchgangsloch eingesetzt ist und mit dem Kontaktabschnitt versehen ist.

4. Verbinder nach Anspruch 2 oder 3,
wobei der erste Isolator (13) und der zweite Isolator (14) Flexibilität aufweisen.

5. Verbinder nach Anspruch 1,
wobei das Kontaktelement (35) ein Kontaktdurchgangsloch (35C) aufweist, das das Kontaktelement in der Stapelrichtung durchdringt, um den Kontaktabschnitt zu passieren, und das mit dem ersten Durchgangsloch in Verbindung steht,
der Haltemechanismus aus dem zweiten Isolator (34) gebildet ist, und
der zweite Isolator (34) den Vorsprung (34F), der durch das Kontaktdurchgangsloch und das erste Durchgangsloch zu der Seite der unteren Oberflächen des ersten Isolators verläuft, und einen Überhangabschnitt (34G), der an einem Ende des Vorsprungs gebildet ist und von dem ersten Durchgangsloch in der vorbestimmten Richtung an der Seite der unteren Oberflächen des ersten Isolators überhängt, beinhaltet.

6. Verbinder nach Anspruch 5,
wobei der zweite Isolator (34) ein zweites Durchgangsloch (34C), das den zweiten Isolator in der Stapelrichtung durchdringt, und einen vertieften Abschnitt (34D), der mit dem zweiten Durchgangsloch in Verbindung steht und sich an der zweiten Trägeroberfläche öffnet, aufweist,
das Kontaktelement (35) einen Kontaktkörper (35A), der in das zweite Durchgangsloch eingesetzt ist, und einen flachen Plattenabschnitt (35B), der an den Kontaktkörper angrenzt und in den vertieften Abschnitt eingesetzt ist, aufweist, und
der Kontaktabschnitt (C) und das Kontaktdurchgangsloch (35C) in dem flachen Plattenabschnitt gebildet sind.

7. Verbinder nach einem der Ansprüche 1 bis 6,
wobei der Kontaktabschnitt (C) mindestens einen Vorsprung (15C, 35D) aufweist, der hin zu der ersten Trägeroberfläche (S1) des ersten Isolators (13, 33) vorsteht.

8. Verbinder nach einem der Ansprüche 1 bis 7,
wobei der erste Isolator (13, 33) mindestens einen Vorsprung (13E, 33E) aufweist, der von der ersten Trägeroberfläche hin zu dem Kontaktabschnitt des Kontaktelements an einer Position, die dem Kontaktabschnitt (C) entspricht, vorsteht.

9. Verbinder nach einem der Ansprüche 1 bis 8, umfassend eine Vielzahl der Kontaktelemente (15, 35), die durch den zweiten Isolator (14, 34) gehalten werden,
wobei der erste Isolator (13, 33) eine Vielzahl der ersten Durchgangslöcher (13C, 33C) aufweist, die der Vielzahl der Kontaktelemente entsprechen, und
ein Teil des schichtartigen Verbindungsobjekts (21), von dem eine Vielzahl der leitfähigen Abschnitte (23) in Richtung der zweiten Trägeroberfläche freiliegt, zwischen der ersten Trägeroberfläche und der zweiten Trägeroberfläche sandwichartig angeordnet ist, und die Kontaktabschnitte der Vielzahl der Kontaktelemente mit der Vielzahl der leitfähigen Abschnitte in Kontakt sind, wodurch die Vielzahl der Kontaktelemente elektrisch mit der Vielzahl der leitfähigen Abschnitte verbunden ist.

## Revendications

1. Connecteur comprenant :
un premier isolant (13, 33) ayant une forme de plaque plate s'étendant le long d'un plan XY et comprenant une surface supérieure (13A, 33A) orientée dans une direction +Z et une surface inférieure (13B, 33B) orientée dans une direction -Z, le premier isolant (13, 33) ayant, sur sa surface supérieure, une première surface de support (S1) s'étendant dans une direction prédéterminée ;
un second isolant (14, 34) ayant une forme de plaque plate s'étendant le long d'un plan XY et comprenant une surface supérieure (14A, 34A) orientée dans la direction +Z et une surface inférieure (14B, 34B) orientée dans la direction -Z, le second isolant étant disposé dans une direction d'empilement perpendiculaire à la direction prédéterminée par rapport au premier isolant et ayant une seconde surface de support (S2) qui fait face à la première surface de support ;
un élément de contact (15, 35) maintenu par le second isolant et ayant une partie de contact (C) exposée au niveau de la seconde surface de support, et
un mécanisme de maintien (15, 34) configuré pour maintenir la partie de contact vers la première surface de support,
dans lequel le premier isolant a un premier trou traversant (13C, 33C) pénétrant le premier isolant dans la direction d'empilement de la première surface de support à une surface inférieure du premier isolant à une position correspondant à la partie de contact,
le mécanisme de maintien a un bossage (15B, 34F) passant à travers le premier trou traversant vers un côté de surface inférieure du premier isolant et maintient la partie de contact vers la première surface de support en utilisant le bossage, et
dans lequel le connecteur est configuré de sorte qu'une partie d'un objet de connexion de type feuille (21), dont une partie conductrice (23) est exposée vers la seconde surface de support, doit être prise en sandwich entre la première surface de support et la seconde surface de support, et la partie de contact doit établir un contact avec la partie conductrice, moyennant quoi l'élément de contact est électriquement connecté à la partie conductrice,
**caractérisé en ce que**
l'élément de contact comprenant un corps de contact (15A, 35A) ayant une hauteur directionnelle Z sensiblement égale à une épaisseur du second isolant, une surface du corps de contact (15A, 35A) sur le côté de direction +Z formant un plan sensiblement identique avec la surface supérieure (14A, 34A) du second isolant et étant exposée à partir du second isolant.

2. Connecteur selon la revendication 1,
dans lequel le mécanisme de maintien est formé de l'élément de contact (15), et
l'élément de contact (15) comprend le bossage (15B) formé pour faire saillie à partir de la partie de contact, et une partie en porte-à-faux (15D) formée au niveau d'une extrémité du bossage et en porte-à-faux à partir du premier trou traversant dans la direction prédéterminée sur le côté de surface inférieure du premier isolant.

3. Connecteur selon la revendication 2,
dans lequel le second isolant (14) a un second trou traversant (14C) pénétrant le second isolant dans la direction d'empilement et s'ouvrant au niveau de la seconde surface de support, et
l'élément de contact (15) a un corps de contact (15A) inséré dans le second trou traversant et pourvu de la partie de contact.

4. Connecteur selon la revendication 2 ou 3,
dans lequel le premier isolant (13) et le second isolant (14) ont une flexibilité.

5. Connecteur selon la revendication 1,
dans lequel l'élément de contact (35) a un trou traversant de contact (35C) qui pénètre l'élément de contact dans la direction d'empilement de manière à faire passer la partie de contact et qui communique avec le premier trou traversant,
le mécanisme de maintien est formé du second isolant (34), et
le second isolant (34) comprend le bossage (34F) passant à travers le trou traversant de contact et le premier trou traversant vers le côté de surface inférieure du premier isolant, et une partie en porte-à-faux (34G) formée au niveau d'une extrémité du bossage et en porte-à-faux à partir du premier trou traversant dans la direction prédéterminée sur le côté de surface inférieure du premier isolant.

6. Connecteur selon la revendication 5,
dans lequel le second isolant (34) a un second trou traversant (34C) pénétrant le second isolant dans la direction d'empilement et une partie évidée (34D) communiquant avec le second trou traversant et s'ouvrant au niveau de la seconde surface de support,
l'élément de contact (35) a un corps de contact (35A) inséré dans le second trou traversant et une partie de plaque plate (35B) adjacente au corps de contact et insérée dans la partie évidée, et
la partie de contact (C) et le trou traversant de contact (35C) sont formés dans la partie de plaque plate.

7. Connecteur selon l'une quelconque des revendications 1 à 6,
dans lequel la partie de contact (C) a au moins une saillie (15C, 35D) faisant saillie vers la première surface de support (S1) du premier isolant (13, 33).

8. Connecteur selon l'une quelconque des revendications 1 à 7,
dans lequel le premier isolant (13, 33) a au moins une saillie (13E, 33E) faisant saillie de la première surface de support vers la partie de contact de l'élément de contact à une position correspondant à la partie de contact (C).

9. Connecteur selon l'une quelconque des revendications 1 à 8, comprenant une pluralité des éléments de contact (15, 35) maintenus par le second isolant (14, 34),
dans lequel le premier isolant (13, 33) a une pluralité des premiers trous traversants (13C, 33C) correspondant à la pluralité des éléments de contact, et
une partie de l'objet de connexion de type feuille (21), dont une pluralité des parties conductrices (23) sont exposées vers la seconde surface de support, est prise en sandwich entre la première surface de support et la seconde surface de support, et les parties de contact de la pluralité des éléments de contact établissent un contact avec la pluralité des parties conductrices, moyennant quoi la pluralité des éléments de contact sont électriquement connectés à la pluralité des parties conductrices.
